(19)

Europäisches
Patentamt
European
Patent Office
Office européen
des brevets

(11)     **EP 3 045 930 B1**

(12)                 **EUROPEAN PATENT SPECIFICATION**

(45) Date of publication and mention
of the grant of the patent:
**16.05.2018   Bulletin 2018/20**

(21) Application number: **14842552.3**

(22) Date of filing: **05.09.2014**

(51) Int Cl.:
*G01R 35/02* (2006.01)          *G01R 31/327* (2006.01)
*G01R 31/06* (2006.01)

(86) International application number:
**PCT/CN2014/085982**

(87) International publication number:
**WO 2015/032343 (12.03.2015 Gazette 2015/10)**

(54) **TESTING SYSTEM OF GIS ELECTRONIC MUTUAL INDUCTOR AND METHOD THEREFOR**

TESTSYSTEM FÜR GEGENSEITIGE ELEKTRONISCHE GIS-INDUKTOREN UND VERFAHREN DAFÜR

SYSTÈME D'ANALYSE D'INDUCTANCE MUTUELLE ÉLECTRONIQUE DE GIS ET PROCÉDÉ ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **09.09.2013   CN 201310407523**

(43) Date of publication of application:
**20.07.2016   Bulletin 2016/29**

(73) Proprietors:
• **State Grid Corporation of China (SGCC)**
  **Beijing 100031 (CN)**
• **China Electric Power Research Institute**
  **Beijing 100192 (CN)**

(72) Inventors:
• **ZHANG, Qin**
  **Beijing 100192 (CN)**
• **YE, Guoxiong**
  **Beijing 100192 (CN)**
• **GUO, Keqin**
  **Beijing 100192 (CN)**
• **LIU, Bin**
  **Beijing 100192 (CN)**
• **HUANG, Hua**
  **Beijing 100192 (CN)**
• **TONG, Yue**
  **Beijing 100192 (CN)**
• **LIU, Xiang**
  **Beijing 100192 (CN)**
• **HU, Bei**
  **Beijing 100192 (CN)**

• **WAN, Gang**
  **Beijing 100192 (CN)**
• **FENG, Xiangxiang**
  **Beijing 100192 (CN)**
• **WU, Wenliang**
  **Beijing 100192 (CN)**
• **CHEN, Peng**
  **Beijing 100192 (CN)**
• **YANG, Fan**
  **Beijing 100192 (CN)**
• **DENG, Xiaopin**
  **Beijing 100192 (CN)**
• **WANG, Yan**
  **Beijing100192 (CN)**
• **WANG, Xiaozhou**
  **Beijing 100192 (CN)**
• **DAI, Jing**
  **Beijing 100192 (CN)**
• **WANG, Yingying**
  **Beijing 100192 (CN)**
• **XIONG, Junjun**
  **Beijing 100192 (CN)**
• **LIU, Yong**
  **Beijing 100192 (CN)**

(74) Representative: **Vidon Brevets & Stratégie**
**16B, rue de Jouanet**
**BP 90333**
**35703 Rennes Cedex 7 (FR)**

(56) References cited:
**CN-A- 101 504 432     CN-A- 101 881 813**
**CN-A- 102 565 647     CN-A- 103 487 780**

CN-U- 203 502 582

## Description

### Field of the Invention

The present invention relates to a GIS electronic instrument transformer test system and a method thereof, and in particular to a GIS electronic instrument transformer test system based on opening-closing small capacity current of an isolating switch and a test method thereof.

### Background of the Invention

With the advancement of smart grids development, electronic instrument transformers are widely used in the smart grids. The strategic objective of "building a unified and strong smart grid" proposed in the science and technology development plan of the State Grid Corporation of China proposes higher requirements on the quality and performance of electronic instrument transformer products and the operation reliability, stability and accuracy of the products. Electromagnetic interference is one of the important factors that affect the reliability and the stability of the electronic instrument transformers.

At present, the detection cognition of the electromagnetic compatibility of the electronic instrument transformers still retains on the basis of existing standards at home and abroad, the test projects and technical requirements cannot fully meet the actual needs of electronic equipment running in high voltage levels. The application and promotion time of domestic electronic instrument transformers is not long, the exposure of the electromagnetic compatibility problem thereof is not very significant, but due to the important role of the electronic instrument transformers in a power system, it is very essential to pay attention to the electromagnetic compatibility problem.

It can be seen from common electromagnetic interference types and characteristics of substations and interference coupling paths of the substations on the electronic instrument transformers, in a substation environment, the main reason why the electronic instrument transformers are interfered easily is that the equipment of the electronic instrument transformers is closer to a primary circuit, under the conditions of switch operation and system short circuit, the electronic instrument transformers are more vulnerable to interference by direct conduction and electromagnetic field coupling, and the layout, merging units and power supply modules thereof are liable to generate interference through electromagnetic radiation or ground potential rise. The intensity of the interference is far more than the current interference level regulated by the current electromagnetic compatibility standards, and this is also the main reason why the current electronic instrument transformers have passed electromagnetic compatibility tests but suffer electromagnetic protection faults on site. In order to completely verify the strong interference resistance of the electronic instrument transformers under onsite conditions, a test method closest to the actual conditions must be adopted for verification. To this end, an electromagnetic compatibility test method meeting onsite electromagnetic protection requirements need to be researched and proposed, in order to improve the protection performance of the electronic instrument transformers and reduce the fault rate of electromagnetic protection.

Prior art is known from CN101881813, CN101504432, and CN102565647.

### Summary of the Invention

The objective of the present invention is to provide a GIS electronic instrument transformer test system based on opening-closing small capacity current of an isolating switch, so that various electromagnetic radiation of the system can be simulated to propose an electromagnetic compatibility test method meeting onsite electromagnetic protection requirements, in order to improve the protection performance of an electronic instrument transformer and reduce the fault rate of electromagnetic protection.

To achieve the objective, the present invention adopts the following technical solutions:

A GIS electronic instrument transformer test system based on opening-closing small capacity current of an isolating switch includes two casings, wherein a GIS pipeline is arranged between the two casings, of which one casing is a power supply casing that is connected with a high voltage test transformer and a capacitive voltage divider used for protecting a power supply, which are connected in parallel, said capacitive voltage divider is used for reducing a resonance effect caused by higher power supply impedance, of which the other casing is a load casing, said load casing is connected with a load capacitor, and a first isolating switch is arranged in the GIS pipeline close to the power supply casing; a first calibration primary transient test system, a first to-be-tested electronic instrument transformer, a second to-be-tested electronic voltage transformer and a second calibration primary transient voltage test system are arranged between the first isolating switch and the load casing; wherein, said first to-be-tested electronic instrument transformer is close to said first isolating switch, said second to-be-tested electronic voltage transformer is close to the load casing, the first to-be-tested electronic instrument transformer is an electronic current transformer or an electronic current and voltage combined transformer, said first calibration primary transient test system is arranged near the first to-be-tested electronic instrument transformer and is a primary transient current test system corresponding to said first to-be-tested electronic instrument transformer or a combination of primary transient voltage and current test systems, and said second calibration primary transient voltage test system is arranged near the second to-be-tested electronic voltage transformer; and one end of a secondary converter is connected with the to-be-tested electronic instrument transformers, the other end of the secondary converter is connected with a merging unit, the other end of the merging unit is connected with a fault recorder, and the fault recorder is used for connecting the output of the merging unit. Preferably, a second isolating switch is further arranged between said first to-be-tested electronic instrument transformer and said second to-be-tested electronic voltage transformer.

Preferably, the length of said GIS pipeline is adjustable, a slide rail for expanding and contracting the GIS pipeline is arranged at a bottom of the power supply casing, and the slide rail can slide left and right.

Preferably, numerical values of small capacity current of opening-closing of the first and second isolating switches are 0.1-0.8A.

Preferably, the output current of the high voltage test transformer is 2A; and the first and second isolating switches are provided with electric operating mechanisms and AC 220V operating power supplies.

Preferably, a control cabinet is installed near the GIS pipeline, and the secondary converter and the merging unit are placed in the control cabinet.

Preferably, the primary transient current test system includes a primary transient current sensor, the primary transient voltage test system includes a primary transient voltage sensor, a high speed collection card and a measurement upper computer, the high speed collection card 3 respectively collects the outputs of the primary transient current sensor and the primary transient voltage sensor and transmits the outputs to the measurement upper computer in a data transmission mode.

Preferably, the primary transient voltage sensor is a hand hole type voltage sensor, the hand hole type voltage sensor includes an induction electrode installed in a GIS hand hole, a hand hole cover plate and an insulating film located between the induction electrode and the hand hole cover plate, a layer of the insulating film is clamped between the induction electrode and the hand hole cover plate to form low voltage arm capacitance of the voltage divider, high voltage arm capacitance is formed between the induction electrode and a high voltage bus to constitute the capacitive voltage divider, so as to measure a transient overvoltage between the high voltage bus and a GIS housing; the primary transient current sensor adopts a hollow coil, and the hollow coil sleeves a current measurement site of the high voltage bus for measurement; and a shielding box is installed at a GIS pull opening, and the high speed collection card, a triggering system, an optical fiber control system and a power supply of the test system are placed in the shielding box.

A test method of the GIS electronic instrument transformer test system based on the opening-closing small capacity current of the isolating switch includes the following steps:

step 1: establishing the GIS electronic instrument transformer test system based on the isolating switch;

step 2: guaranteeing to place the merging unit in the control cabinet, wherein the merging unit is normally powered to run and normally communicates with the fault recorder;

step 3: closing the second isolating switch, locating the first isolating switch in a opening state, and raising the output voltage of the high voltage test transformer to $\mathrm{Um}/\sqrt{3}$, wherein Um refers to the highest voltage of the circuit;

step 4: closing the first isolating switch, and recording two pieces of test data of the test system and secondary fault recording data;

step 5: turning on the first isolating switch DS1 2 minutes later, and recording the two pieces of test data of the test system and the secondary fault recording data;

step 6: repeating the step 4 to the step 5 for 9 times, namely carrying out the opening-closing operation of the first isolating switch for 10 times in total.

Preferably, the method further includes the following steps:

step 7: closing the first isolating switch, locating the second isolating switch in an opening state, and raising the output voltage of the high voltage test transformer to $\mathrm{Um}/\sqrt{3}$, wherein Um refers to the highest voltage of the circuit;

step 8: closing the second isolating switch, and recording test data 101 and 104 of the primary transient test system and secondary fault recording data;

step 9: turning on the second isolating switch DS2 2 minutes later, and recording the test data 101 and 104 of the primary transient test system and the secondary fault recording data;

step 10: repeating the step 8 to the step 9 for 9 times, namely carrying out the opening-closing operation of the second isolating switch for 10 times in total, and then ending the test.

Therefore, according to the GIS electronic instrument transformer test system based on the opening-closing small capacity current of the isolating switch in the present invention, when the isolating switch is opened and closed, a voltage value and a current valve of the high voltage bus in the GIS pipeline are tested to compare with the output of a product to be tested. In this case, 110KV, 220KV and 500KV test circuits for the opening-closing small capacity current of the isolating switch can be established in a lab, meanwhile, the electronic instrument transformer is serially connected to the test circuit to simulate load processes of opening-closing empty conducting wires and small capacity current of the isolating switch onsite, in order to generate similar onsite transient strong interference to check the electromagnetic protection performance of the electronic instrument transformer under the condition. The test platform can be applied to electromagnetic environments of 110KV, 220KV and 500KV voltage levels in power transmission and outage processes.

Brief Description of the Drawings

Fig.1 is an installation size diagram of a 220KV GIS pipeline based on an embodiment of the present invention;
Fig.2 is a 220KV test circuit diagram based on an embodiment of the present invention;
Fig.3 is a 220KV test layout diagram based on an embodiment of the present invention;
Fig.4 is a structure diagram of a hand hole type voltage sensor based on an embodiment of the present invention;
Fig.5 is an installation structure diagram of a primary transient voltage sensor of a GIS pipeline based on an embodiment of the present invention;
Fig.6 is an installation structure diagram of a primary transient current sensor of a GIS pipeline based on an embodiment of the present invention;

Accompany drawing marks in the figures respectively represent the following components:

101 represents a first calibration primary transient test system; 102 represents a first to-be-tested electronic instrument transformer; 103 represents a second to-be-tested electronic voltage transformer; 104 represents a second calibration primary transient voltage test system; 105 represents a power supply casing; 106 represents a load casing; 110 represents a secondary converter; 111 represents a merging unit; 112 represents a fault recorder; 113 represents a high speed collection card; 114 represents a measurement upper computer; 201 represents a high voltage bus; 202 represents an induction electrode; 203 represents an insulating film; 204 represents a hand hole cover plate; 205 represents a hand hole; 206 represents a GIS housing; 301 represents a shielding box; 302 represents a storage battery; 303 represents an inverter power supply; 1 represents a position 1; 2 represents a position 2; 3 represents a position 3; and 4 represents a position 4.

**Detailed Description of the Embodiments**

The present invention will be further illustrated below in detail in combination with the accompany drawings and embodiments. It can be understood that, the specific embodiments described herein are merely used for explaining the present invention, rather than limiting the present invention. It should be additionally noted that, for the convenience of description, only parts related to the present invention, rather than all structures, are shown in the accompany drawings.

An electromagnetic environment of a substation mainly includes an isolating switch and a strong electromagnetic interference phenomenon generated in the substation under circuit breaker operation, lightning, system short circuit and other conditions.

A lightning impulse test carried out in a lab is used as a test method for checking the anti-electromagnetic interference ability of an electronic instrument transformer, but considering the energy of an artificial lightning impulse test and the entire test layout condition, the lightning impulse test carried out in the lab has relatively large difference with the real condition of discharging along a lightning conductor in the substation, and firstly, lightning current amplitude and energy simulated under artificial conditions are significantly weaker than those under actual conditions; and secondly, in the artificial test, the layout of test equipment is inconsistent with the actual conditions obviously. Therefore, the artificial lightning test cannot fully simulate actual onsite conditions, and thus the test result is not too good.

An artificial ground test carried out in the lab also has similar problems, the biggest defect thereof is that the conditions of artificially simulated short circuit current have large difference with the actual conditions, and the amplitude and the duration thereof and the like are obviously weaker than those under the actual conditions, therefore the check of the anti-electromagnetic interference ability of the electronic instrument transformer under artificial ground test conditions are insufficient as well. If a 1: 1 true artificial ground test is carried out on the substation, better test conditions can be provided to check the electronic instrument transformer, but the danger of the test is large, and strong interference is generated on most weak current equipment in the substation. The test may cause unnecessary losses or retain hidden trouble to generate certain danger to the subsequent normal operation of the substation, and thus similar tests are scarcely carried out in a power system.

Therefore, the artificial lightning impulse test and the artificial ground test have obvious defects. By theoretical analysis and practical experience, relatively strong electromagnetic interference can be generated by the operation of an onsite isolating switch, and the features of the isolating switch interference source are as follows:

1) an overvoltage is generated in a primary circuit, and the amplitude range of the overvoltage is 1.0p.u. to 2.8 p.u.;
2) high frequency pulse current is generated in the primary circuit, and the amplitude range of the high frequency pulse current is thousands of amperes;
3) the range of primary voltage and current frequency is wide and is 50Hz to 100MHz;
4) the harassment duration is long and is 200ms to several seconds;
5) arc breakdown-extinguishment discharge is generated for multiple times, ranging from hundreds of times to thousands of times;
6) electromagnetic radiation is generated;
7) housing potential rise is generated, and the amplitude range thereof is thousands of volts to tens of thousands of volts.

Therefore, it can be known that the isolating switch interference source is a high-intensity interference source. If used in an electromagnetic compatibility test for checking the electronic instrument transformer, the isolating switch interference source can be used for checking the electromagnetic protection performance of the electronic instrument transformer to the uttermost. In a capacitor opening and closing process, the isolating switch generates an arc breakdown-extinguishment transient process for multiple times in a primary test circuit, pulse current, a transient overvoltage and a pulse electromagnetic field will be generated in the transient process for multiple times, numerical values of primary voltage and current are measured and recorded by standard voltage and standard current sensors in the primary circuit, an output value processed by a merging unit of the tested electronic instrument transformer is recorded at the same time, and the measured numerical values of the primary voltage and current waveforms are compared with the output properties of the tested electronic instrument transformer and the working state of the electronic instrument transformer in the entire test process is observed so as to judge the anti-electromagnetic interference ability of the tested electronic instrument transformer.

Embodiment 1:

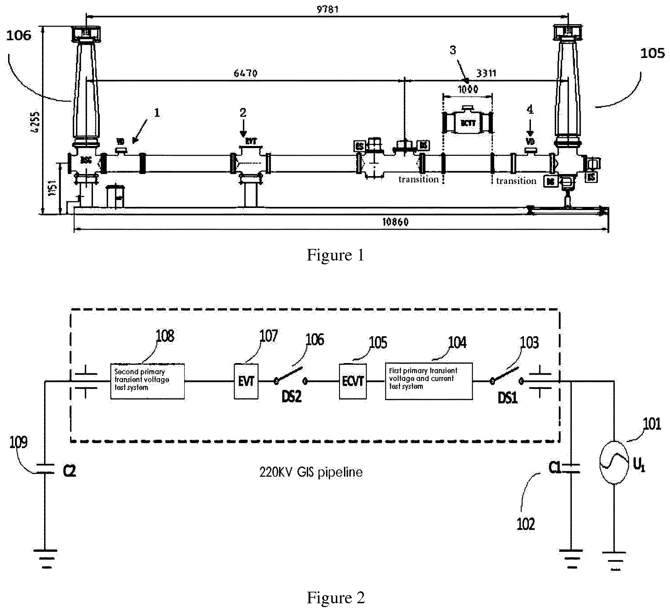

In the embodiment, with a 220KV GIS pipeline as an example, a GIS electronic instrument transformer test system is introduced. Referring to Fig.1 to Fig.3, they are respectively an installation size diagram, a test circuit diagram and a test layout diagram of the 220KV GIS pipeline according to the present invention.

The GIS electronic instrument transformer test system includes two BSG casings, a GIS pipeline is arranged between the two BSG casings, one casing is a power supply casing 105, the power supply casing is connected with a high voltage test transformer U1 and a capacitive voltage divider C1 used for protecting a power supply, which are connected in parallel each other, the capacitive voltage divider C1 is used for reducing a resonance effect caused by higher power supply impedance, the other casing is a load casing 106, the load casing is connected with a load capacitor C2, and since all GIS electronic instrument transformers belong to products with relatively small capacitance and based on the capacitive voltage division principle, the load capacitor C2 needs to be added to better simulate the actual conditions. Specifically, the load capacitor C2 is conducive to stabilizing bus charging current, and the error is +/-10%. A first isolating switch DS1 is arranged in the GIS pipeline close to the power supply casing, and a first calibration primary transient test system 101, a first to-be-tested electronic instrument transformer 102, a second to-be-tested electronic voltage transformer 103 and a second calibration primary transient voltage test system 104 are arranged between the first isolating switch DS1 and the load casing. The first to-be-tested electronic instrument transformer 102 is close to the first isolating switch DS1, the second to-be-tested electronic voltage transformer 103 is close to the load casing, wherein the first to-be-tested electronic instrument transformer 102 is an electronic current transformer ECT or an electronic current and voltage combined transformer ECVT, the reason why the second to-be-tested electronic voltage transformer EVT is arranged is that the influence of a distance away from the isolating switch on the transient voltage is relatively large, the second to-be-tested electronic voltage transformer is additionally arranged between the first to-be-tested electronic instrument transformer and the load casing. One end of a secondary converter 110 is connected with the to-be-tested electronic instrument transformers 102 and 103, the other end of the secondary converter is connected with a merging unit 111, the other end of the merging unit 111 is connected with a fault recorder 112, and the fault recorder 112 is used for connecting the output of the merging unit 111.

The first calibration primary transient test system 101 is arranged near the first to-be-tested electronic instrument transformer 102 and is a primary transient current test system corresponding to the first to-be-tested electronic instrument transformer or a combination of primary transient voltage and current test systems. The second calibration primary transient voltage test system 104 is arranged near the second to-be-tested electronic voltage transformer 103 and is a primary transient voltage test system corresponding to the second to-be-tested electronic voltage transformer.

It should be aware that, the specific positions of the to-be-tested electronic instrument transformer in the GIS pipeline are not fixed, the to-be-tested electronic instrument transformer can be located at different positions in the pipeline, and thus the transient voltage or current at different positions away from the first isolating switch DS1 can be simulated.

In the solution, the to-be-tested electronic instrument transformers 102 and 103 are located on a load side, namely located between the first isolating switch DS1 and the load casing, and only the distances away from the isolating switch are different, and thus the influence of the length of the pipeline on the transient voltage and the transient current on the load side can be researched.

Therefore, preferably, the length of the GIS pipeline is adjustable, a slide rail for expanding and contracting the GIS pipeline is arranged at a bottom of the power supply casing 105 and can slide left and right, so that different GIS pipelines can be simulated, which is further conducive to searching the influence of lengths of the different GIS pipelines on the transient voltage and the transient current on the load side.

Meanwhile, the adjustable length of the GIS pipeline and the telescopic slide rail can be compatible to samples of electronic instrument transformers from different manufacture companies.

Preferably, in order to research the difference of the transient current and the transient voltage on the load side and a power supply side, an auxiliary second isolating switch DS2 is further arranged between the first to-be-tested electronic instrument transformer and the second to-be-tested electronic voltage transformer, in this way, the test ability of the current is expanded, and thus the test circuit can be used for researching transient parameters in the following two manners:

First manner: a power supply is placed on the right side, a load is placed on the left side, the DS2 is normally closed, the DS1 is opened, data tested by two transient test systems are transient voltage waveforms of the load side (between the isolating switch and the load), and only the distances away from the isolating switch are different, so that the influence of the length of the pipeline on the transient voltage of the load side can be researched.

Second manner: the power supply is placed on the right side, the load is placed on the left side, the DS1 is normally closed, the DS2 is opened, the data tested by the two transient test systems are respectively transient voltage waveforms of the load side (between the isolating switch and the load) and the power supply side (between the isolating switch and the power supply), and thus the difference of the transient voltages of the load side and the power supply side can be researched.

Wherein, the first calibration primary transient test system and the second calibration primary transient voltage test system can be common primary transient current and voltage measurement systems, but preferably, can be the primary transient current and voltage measurement systems of embodiment 2 as an example.

As mentioned above, the positions of the to-be-tested electronic instrument transformers in the GIS pipeline are not fixed and the to-be-tested electronic instrument transformers can be located at different positions in the pipeline, so that the transient voltage or current at different positions away from the first isolating switch DS1 can be simulated.

For example, specific positions of the to-be-tested transformers and the primary transient test system can be set in 220KV. Referring to Fig.1 to Fig.3, in the figures, ES represents a ground switch, DS represents an isolating switch, EVT represents a test sample of an electronic voltage transformer, ECT represents a test sample of an electronic current transformer, and ECVT represents a test sample of an electronic current and voltage combined transformer. One EVT can be connected to a position 2 and the ECT or the ECVT can be installed at a position 3 of the test platform at the same time. A primary transient voltage sensor is respectively placed at each of a position 1 and a position 4, and a primary transient current sensor is placed at the position 4.

That is, the first calibration primary transient current and voltage test system, the first to-be-tested electronic combined current and voltage transformer, the second isolating switch, the second to-be-tested electronic voltage transformer and the second calibration primary transient voltage test system are installed between the first isolating switch DS1 and the load casing in sequence.

Those skilled in the art can set the to-be-tested electronic instrument transformers and the primary transient test systems at different positions of the pipeline in different voltage levels, as long as the to-be-tested electronic current transformer or the to-be-tested electronic current and voltage combined transformer is arranged at the position close to the power supply casing, the to-be-tested electronic voltage transformer is additionally arranged near the load casing, and the corresponding calibration primary transient test systems are arranged respectively.

Preferably, the output current of the high voltage test transformer 101 is 2A; and the GIS first isolating switch DS1 and the GIS second isolating switch DS2 are provided with electric operating mechanisms and AC 220V operating power supplies. In actual measurement, a control cabinet is installed near the GIS pipeline, the secondary converter 110 and the merging unit 110 of the to-be-tested electronic instrument transformer are placed in the control cabinet, the power supply of the control cabinet is DC 220KV, and the control cabinet is powered by a DC screen.

According to related standard contents of the isolating switch, in the test, numerical values of small capacity current of opening-closing of the first and second isolating switches are 0.1-0.8A (steady state), and specific numerical values refer to table 1. The actual load capacitance does not need to be accurately consistent with a calculation result, and an error of +/-10% can exist according to actual conditions.

Table 1 Current of Test Capacitor

| Rated voltage/ KV | 72.5 | 126 | 252 | 363 | 550 | 800 |
|---|---|---|---|---|---|---|
| Current/A | 0.1 | 0.1 | 0.25 | 0.5 | 0.5 | 0.5 |

In the test, due to the internal resistance of the high voltage test transformer 101 in a switching-on state and an opening state, the steady state voltage thereof changes, and the power supply change thereof should be not larger than +/-10% according to the requirements of GB1985-2004 "high voltage AC isolating switch and ground switch".

In the test, a primary part, a secondary connection and the electronic merging unit of the tested electronic instrument transformer are completely assembled and connected according to actual use conditions, and the electronic instrument transformer is powered and operates according to normal working conditions in the test process.

Embodiment 2:

Opening-closing small capacity current of an isolating switch is used for testing the electromagnetic compatibility of an electronic instrument transformer, and the basic principle is to test the electromagnetic compatibility of the electronic instrument transformer under a condition of generating strong electromagnetic interference, therefore a strong electromagnetic interference condition parameter is one of the important parameters of the test. Main parameters in the process of the opening-closing small capacity current of the isolating switch include: voltage, current, an electric field, a magnetic field and housing potential rise. Wherein, the voltage and the current are the most important parameters, and thus measurement of the voltage and the current is the critical step for testing the immunity to interference of the electronic instrument transformer under the condition of the opening-closing small capacity current of the isolating switch.

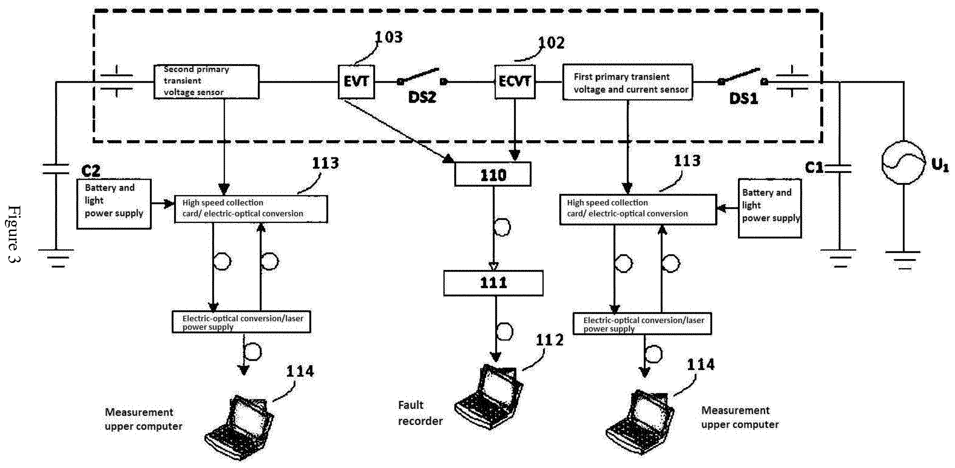

Referring to Fig.3, with 220KV as an example, the first calibration primary transient current and voltage test system and the second calibration primary transient voltage test system according to the embodiment of the present invention are included, wherein the first calibration primary transient current and voltage test system 101 includes a primary transient current sensor, a primary transient voltage sensor, a high speed collection card 113 and a measurement upper computer 114, the high speed collection card 113 respectively collects the outputs of the primary transient current sensor and the primary transient voltage sensor and transmits the outputs to the measurement upper computer 114 in a data transmission mode, for example, photovoltaic conversion, to carry out subsequent data processing. The second calibration primary transient voltage test system 104 includes a primary transient voltage sensor, and the high speed collection card 113 collects the output of the primary transient voltage sensor and transmits the output to the measurement upper computer 114 in the data transmission mode, for example, photovoltaic conversion, to carry out subsequent data processing.

In actual use, the high speed collection card 113 is powered by laser power supply, battery or solar power supply. The measurement upper computer can adopt any available calculating device, such as an industrial control computer, a notebook computer and a PC.

Namely, the test system includes a corresponding standard sensor, and the high speed collection card 113 collects the output of the standard sensor and transmits the output to the measurement upper computer 114 in the data transmission mode, for example, photovoltaic conversion, to carry out subsequent data processing.

In actual measurement, a control cabinet is installed near the GIS pipeline, and a secondary converter and a merging unit of the to-be-tested electronic instrument transformer are placed in the control cabinet. The high speed collection card and a battery power supply module of the transient test system are placed in a shielding box on the outer wall of the GIS pipeline. A notebook computer upper computer and a fault recorder are placed in a personnel operating room.

In particular, a transient electromagnetic process of an operation of the isolating switch is a very complex process, has the features of a wide bandwidth (50Hz to 100MHz) and a long duration (several seconds), and has higher requirements on the measurement frequency bands, the anti-interference performance and the length of recorded data of a pre-probe and a measurement system, and thus "professional measurement" is required in related standards.

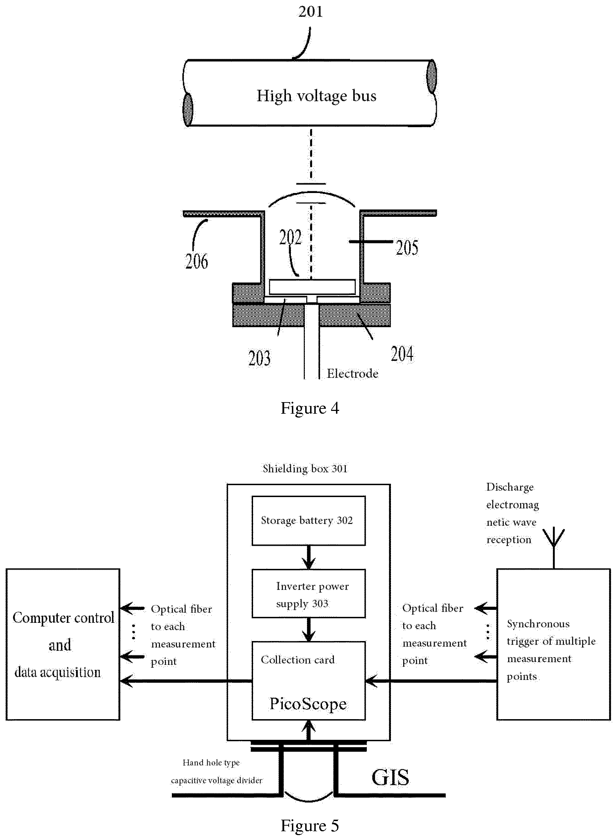

Therefore, referring to Fig.4, a structure diagram of a GIS calibration primary transient voltage sensor based on the capacitive voltage division principle is disclosed, and the calibration primary transient voltage sensor is a hand hole type voltage sensor. The hand hole type voltage sensor includes an induction electrode 202 installed in a GIS hand hole 205, a hand hole cover plate 204 and an insulating film 203 located between the induction electrode and the hand hole cover plate, wherein the insulating film can be a plastic film. A layer of the insulating film 203 is clamped between the induction electrode 202 and the hand hole cover plate 204 to form low voltage arm capacitance of a voltage divider, high voltage arm capacitance is formed between the induction electrode 202 and a high voltage bus 201 to constitute the capacitive voltage divider, so as to measure a transient overvoltage between the high voltage bus in GIS and a GIS housing.

During specific installation, referring to Fig.5, an installation structure diagram of a primary transient voltage sensor of a GIS pipeline is disclosed exemplarily. A shielding box 301 is independently installed at the outside of the hand hole 205, an oscilloscope type high speed collection card 113, a triggering system (not shown in the figure), an optical fiber control system (not shown in the figure) and a power supply of the test system are placed in the shielding box 301, and the shielding box 301 is directly installed on a pull opening of GIS to prevent the influence of radiated electromagnetic interference and conducted electromagnetic interference on the measurement system. The power supply includes a storage battery 302 and an inverter power supply 303.

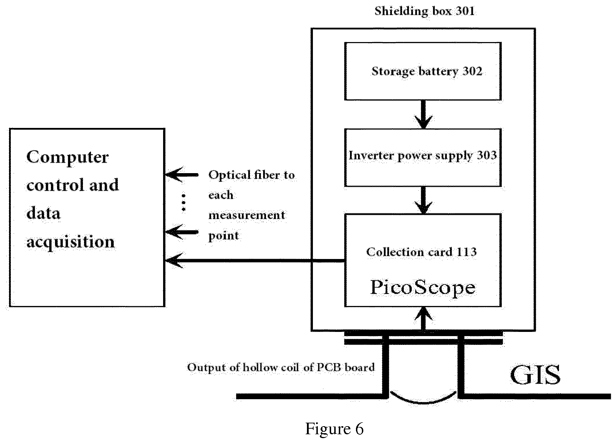

The GIS calibration primary transient current sensor adopts a hollow coil, and the hollow coil sleeves a current measurement site of the high voltage bus for measurement. Referring to Fig.6, it is an installation structure diagram of a primary transient current sensor of a GIS pipeline based on an embodiment of the present invention, the hollow coil outputs to the oscilloscope type high speed collection card 113 for measurement, similarly, the shielding box 301 is independently installed at the outside of the hand hole, the oscilloscope type high speed collection card 113, the triggering system (not shown in the figure), the optical fiber control system (not shown in the figure) and the power supply of the test system are placed in the shielding box 301, and the shielding box 301 is directly installed on a pull opening of GIS to prevent the influence of radiated electromagnetic interference and conducted electromagnetic interference on the measurement system. The power supply includes the storage battery 302 and the inverter power supply 303.

It should be aware that, the principles of the calibration primary transient voltage and current systems of different voltage levels are the same, and high voltage arm capacitance can be determined according to determined voltage division ratio of a capacitive sensor and low voltage arm capacitance. A GIS structural size, a hand hole diameter, an electrode diameter and a thickness are given, and a hand hole depth is selected to obtain the required high voltage arm capacitance. By means of electric field simulation, coupling capacitance among multiple conductors can be calculated, and the designed size of the GIS hand hole is determined according to the necessary high voltage arm capacitance.

Embodiment 3:

The embodiment discloses a test method utilizing the GIS electronic instrument transformer test system based on the embodiments 1 and 2.

The test method includes the following steps:

1. establishing the GIS electronic instrument transformer test system based on the isolating switch according to Fig.1-3;
2. guaranteeing to place the merging unit 111 in the control cabinet, wherein the merging unit is normally powered to run and normally communicates with the fault recorder 112;
3. closing the second isolating switch DS2, locating the first isolating switch DS1 in an opening state, and raising the output voltage of the high voltage test transformer to $Um/\sqrt{3}$ wherein Um refers to the highest voltage of the circuit;
4. closing the first isolating switch, and recording test data 101 and 104 of the primary transient test system and secondary fault recording data;
5. turning on the first isolating switch DS1 2 minutes later, and recording the test data 101 and 104 of the primary transient test system and the secondary fault recording data;
6. repeating the step 4 to the step 5 for 9 times, namely carrying out the opening-closing operation of the first isolating switch for 10 times in total.

In this way, the first part of test is terminated. In the part of test, the data tested by two transient voltage test systems are transient voltage waveforms of the load side (between the isolating switch and the load), and only the distances away from the isolating switch are different.

Further, the first isolating switch DS1 can be normally closed, the DS2 is opened, and the data tested by the two transient voltage test systems are respectively the transient voltage waveforms of the load side (between the isolating switch and the load) and the power supply side (between the isolating switch and the power supply), and thus the difference of the transient voltages of the load side and the power supply side can be researched.

Therefore, the method further includes the following steps:

7. closing the first isolating switch DS1, locating the second isolating switch DS2 in an opening state, and raising the output voltage of the high voltage test transformer to $\text{Um}/\sqrt{3}$, wherein Um refers to the highest voltage of the circuit;

8. closing the second isolating switch DS2, and recording the test data 101 and 104 of the primary transient test system and the secondary fault recording data;

9. turning on the second isolating switch DS2 2 minutes later, and recording the test data 101 and 104 of the primary transient test system and the secondary fault recording data;

10. repeating the step 8 to the step 9 for 9 times, namely carrying out the opening-closing operation of the second isolating switch DS2 for 10 times in total, and then ending the test.

In the test, it should be noted that, the test samples are not damaged; communication interruption, packet loss, quality change of the merging unit do not occur; and output abnormality of the merging unit is not allowed (single-point output of the output abnormality exceeds 100% of rated secondary output or the output of two continuous points exceeds 40% of the rated secondary output).

Therefore, according to the GIS electronic instrument transformer test system based on the opening-closing small capacity current of the isolating switch in the present invention, when the isolating switch is opened and closed, a voltage value and a current valve of the high voltage bus are tested to compare with the output of a product to be tested.

The present invention is beneficial to solving the electromagnetic compatibility problem of the primary circuit and improving the electromagnetic compatibility protection measures. Meanwhile, a design of standard high frequency current and voltage sensors is further proposed.

In this case, 110KV, 220KV and 500KV test circuits for the opening-closing small capacity current of the isolating switch can be established in a lab, meanwhile, the electronic instrument transformer is serially connected to the test circuit to simulate load processes of opening-closing empty conducting wires and small capacity current of the isolating switch onsite, in order to generate similar onsite transient strong interference to check the electromagnetic protection performance of the electronic instrument transformer under the condition. The test platform can be applied to electromagnetic environments in power transmission and outage processes of 110KV, 220KV and 500KV voltage levels.

The foregoing contents are further detailed illustration of the present invention in combination with the specific preferred embodiments, the specific embodiments of the present invention should not be deemed as being limited thereto, those of ordinary skill in the art to which the present invention belongs can also make a variety of simple deductions or substitutions without departing from the inventive concept of the present invention, and these deductions or substitutions shall fall into the protection scope determined by the submitted claims.

**Claims**

1. A GIS electronic instrument transformer test system based on opening-closing small capacity current of an isolating switch, comprising:

two casings, wherein a GIS pipeline is arranged between the two casings, one casing is a power supply casing (105), the power supply casing is connected with a high voltage test transformer (U1) and a capacitive voltage divider (C1) used for protecting a power supply, which are connected in parallel each other, the capacitive voltage divider is used for reducing a resonance effect caused by higher power supply impedance, the other casing is a load casing (106), the load casing is connected with a load capacitor (C2), and a first isolating switch (DS1) is arranged in the GIS pipeline close to the power supply casing, is **characterized in that**:

a first calibration primary transient test system (101), a first to-be-tested electronic instrument transformer (102), a second to-be-tested electronic voltage transformer (103) and a second calibration primary transient voltage test system (104) are arranged between the first isolating switch and the load casing;

wherein, the first to-be-tested electronic instrument transformer is close to the first isolating switch, the second to-be-tested electronic voltage transformer is close to the load casing, the first to-be-tested electronic instrument transformer is an electronic current transformer or an electronic combined current and voltage transformer, the first calibration primary transient test system is arranged near the first to-be-tested electronic instrument transformer and is a primary transient current test system corresponding to the first to-be-tested electronic instrument transformer or a combination of primary transient voltage and current test systems, and the second calibration primary transient voltage test system is arranged near the second to-be-tested electronic voltage transformer; one end of a secondary converter is connected with the to-be-tested electronic instrument transformers, the other end of the secondary converter is connected with a merging unit, the other end of the merging unit is connected with a fault recorder, and the fault recorder is used for connecting the output of the merging unit.

2. The GIS electronic instrument transformer test system based on the opening-closing small capacity current of the isolating switch of claim 1, wherein a second isolating switch is further arranged between the first to-be-tested electronic instrument transformer and the second to-be-tested electronic voltage transformer.

3. The GIS electronic instrument transformer test system based on the opening-closing small capacity current of the isolating switch of claim 2, wherein the length of the GIS pipeline is adjustable, a slide rail for expanding and contracting the GIS pipeline is arranged at a bottom of the power supply casing, and the slide rail can slide left and right.

4. The GIS electronic instrument transformer test system based on the opening-closing small capacity current of the isolating switch of claim 2, **characterized in that**:
preferably, numerical values of small capacity current of opening-closing of the first and second isolating switches are 0.1-0.8A.

5. The GIS electronic instrument transformer test system based on the opening-closing small capacity current of the isolating switch of claim 2, **characterized in that**: the output current of the high voltage test transformer is 2A; and the first and second isolating switches are provided with electric operating mechanisms and AC 220V operating power supplies.

6. The GIS electronic instrument transformer test system based on the opening-closing small capacity current of the isolating switch of any one of claims 3-5, wherein a control cabinet is installed near the GIS pipeline, and the secondary converter and the merging unit are placed in the control cabinet.

7. The GIS electronic instrument transformer test system based on the opening-closing small capacity current of the isolating switch of claim 6, wherein the primary transient current test system comprises a primary transient current sensor, the primary transient voltage test system comprises a primary transient voltage sensor, a high speed collection card and a measurement upper computer, the high speed collection card 3 respectively collects the outputs of the primary transient current sensor and the primary transient voltage sensor and transmits the outputs to the measurement upper computer in a data transmission mode.

8. The GIS electronic instrument transformer test system based on the opening-closing small capacity current of the isolating switch of claim 7, wherein the primary transient voltage sensor is a hand hole type voltage sensor, the hand hole type voltage sensor comprises an induction electrode installed in a GIS hand hole, a hand hole cover plate and an insulating film located between the induction electrode and the hand hole cover plate, a layer of the insulating film is clamped between the induction electrode and the hand hole cover plate to form low voltage arm capacitance of the voltage divider, high voltage arm capacitance is formed between the induction electrode and a high voltage bus to constitute the capacitive voltage divider, so as to measure a transient overvoltage between the high voltage bus and a GIS housing; the primary transient current sensor adopts a hollow coil, and the hollow coil is sleeved at a current measurement site of the high voltage bus for measurement; a shielding box is installed at a GIS pull opening, and the high speed collection card, a triggering system, an optical fiber control system and a power supply of the test system are placed in the shielding box.

9. A test method using the GIS electronic instrument transformer test system of claim 7 or 8, **characterized in that** said method includes the following steps:

step 1: establishing the GIS electronic instrument transformer test system based on the isolating switch;
step 2: guaranteeing to place the merging unit in the control cabinet, wherein the merging unit is normally powered to run and normally communicates with the fault recorder;
step 3: closing the second isolating switch, locating the first isolating switch in an opening state, and raising the output voltage of the high voltage test transformer to $\mathrm{Um}/\sqrt{3}$, wherein Um refers to the highest voltage of the circuit;
step 4: closing the first isolating switch, and recording two pieces of test data of the test system and secondary fault recording data;

step 5: turning on the first isolating switch DS1 2 minutes later, and recording the two pieces of test data of the test system and the secondary fault recording data;

step 6: repeating the step 4 to the step 5 for 9 times, namely carrying out the opening-closing operation of the first isolating switch for 10 times in total.

10. The test method of claim 9, **characterized by** further comprising the following steps:

step 7: closing the first isolating switch, locating the second isolating switch in an opening state, and raising the output voltage of the high voltage test transformer to $\mathrm{Um}/\sqrt{3}$ wherein Um refers to the highest voltage of the circuit;

step 8: closing the second isolating switch, and recording test data 101 and 104 of the primary transient test system and secondary fault recording data;

step 9: turning on the second isolating switch DS2 2 minutes later, and recording the test data 101 and 104 of the primary transient test system and the secondary fault recording data;

step 10: repeating the step 8 to the step 9 for 9 times, namely carrying out the opening-closing operation of the second isolating switch DS2 for 10 times in total, and then ending the test.

**Patentansprüche**

1. Elektronisches Messwandlertestsystem für GIS, basierend auf einem geringkapazitiven Öffnungs-/Schließstrom eines Trennschalters, umfassend:
   zwei Gehäuse, wobei eine GIS-Leitung zwischen den zwei Gehäusen angeordnet ist, ein Gehäuse ein Energieversorgungsgehäuse (105) ist, das Energieversorgungsgehäuse mit einem Hochspannungstestwandler (U1) und einem kapazitiven Spannungsteiler (C1), der zum Schutz der Energieversorgung dient, verbunden ist, die parallel zueinander verbunden sind, wobei der kapazitive Spannungsteiler zum Reduzieren eines Resonanzeffekts dient, der durch eine höhere Leistungsversorgungsimpedanz verursacht wird, das andere Gehäuse ein Lastgehäuse (106) ist, das Lastgehäuse mit einem Lastkondensator (C2) und einem ersten Trennschalter (DS1) verbunden ist, angeordnet in der GIS-Leitung nahe dem Energieversorgungsgehäuse, **dadurch gekennzeichnet, dass**:

   ein erstes Kalibrierungsprimärtransiententestsystem (101), ein erster zu testender elektronischer Messwandler (102), ein zweiter zu testender elektronischer Spannungswandler (103) und ein zweites Kalibrierungsprimärtransientenspannungstestsystem (104) zwischen dem ersten Trennschalter und dem Lastgehäuse angeordnet sind;
   wobei der erste zu testende elektronische Messwandler nahe zum ersten Trennschalter ist, der zweite zu testende elektronische Spannungswandler nahe zum Lastgehäuse ist, der erste zu testende elektronische Messwandler ein elektronischer Stromwandler oder ein elektronischer kombinierter Strom- und Spannungswandler ist, das erste Kalibrierungsprimärtransiententestsystem nahe zum ersten zu testenden elektronischen Messwandler angeordnet und ein Primärtransientenstromtestsystem ist, das dem ersten zu testenden elektronischen Messwandler oder einer Kombination eines primären transienten Spannungs- oder Stromtestsystems entspricht, und das zweite Kalibrierungsprimärtransientenspannungstestsystem nahe dem zweiten zu testenden elektronischen Spannungswandler angeordnet ist; ein Ende des zweiten Wandlers mit dem zu testenden elektronischen Messwandler verbunden ist, das andere Ende des zweiten Wandlers mit einer Zusammenführeinheit verbunden ist, das andere Ende der Zusammenführeinheit mit einem Fehlerschreiber verbunden ist und der Fehlerschreiber zum Verbinden des Ausgangs der Zusammenführeinheit dient.

2. Elektronisches Messwandlertestsystem für ein GIS, basierend auf einem geringkapazitiven Öffnungs-/Schließstrom eines Trennschalters nach Anspruch 1, wobei ein zweiter Trennschalter zwischen dem ersten zu testenden elektronischen Messwandler und dem zweiten zu testenden elektronischen Spannungswandler angeordnet ist.

3. Elektronisches Messwandlertestsystem für ein GIS, basierend auf einem geringkapazitiven Öffnungs-/Schließstrom eines Trennschalters nach Anspruch 2, wobei die Länge der GIS-Leitung verstellbar ist, eine Gleitschiene zum Aufweiten und Zusammenziehen der GIS-Leitung an einem Boden des Energieversorgungsgehäuses angeordnet ist und die Gleitschiene nach Links und Rechts verschiebbar ist.

4. Elektronisches Messwandlertestsystem für ein GIS, basierend auf einem geringkapazitiven Öffnungs-/Schließstrom eines Trennschalters nach Anspruch 2, **dadurch gekennzeichnet, dass**:
vorzugsweise numerische Werte des geringkapazitiven Stroms des Öffnens/Schließens des ersten und zweiten Trennschalters 0,1 bis 0,8 A sind.

5. Elektronisches Messwandlertestsystem für ein GIS, basierend auf einem geringkapazitiven Öffnungs-/Schließstrom eines Trennschalters nach Anspruch 2, **dadurch gekennzeichnet, dass**: der Ausgangsstrom des Hochspannungstestwandlers 2 A ist; und der erste und zweite Trennschalter mit einem elektrischen Betriebsmechanismus bereitgestellt sind und 220 V AC Betriebsspannung bereitstellen.

6. Elektronisches Messwandlertestsystem für ein GIS, basierend auf einem geringkapazitiven Öffnungs-/Schließstrom eines Trennschalters nach einem der Ansprüche 3 bis 5, wobei ein Steuerschrank nahe der GIS-Leitung installiert ist und der zweite Wandler und die Zusammenführeinheit in dem Steuerschrank angeordnet sind.

7. Elektronisches Messwandlertestsystem für ein GIS, basierend auf einem geringkapazitiven Öffnungs-/Schließstrom eines Trennschalters nach Anspruch 6, wobei das Primärtransientenstromtestsystem einen Primärtransientenstromsensor umfasst, das Primärtransientenspannungstestsystem einen Primärtransientenspannungssensor, eine Hochgeschwindigkeitssammelkarte und einen Mess-Oberrechner umfasst, wobei die Hochgeschwindigkeitssammelkarte 3 entsprechend die Ausgänge des Primärtransientenstromsensors und des Primärtransientenspannungssensors sammelt und die Ausgänge zum Mess-Oberrechner in einem Datenübertragungsmodus überträgt.

8. Elektronisches Messwandlertestsystem für ein GIS, basierend auf einem geringkapazitiven Öffnungs-/Schließstrom eines Trennschalters nach Anspruch 7, wobei der Primärtransientenspannungssensor ein Handlochtypspannungssensor ist, der Handlochtypspannungssensor eine in einem GIS-Handloch installierte Induktionselektrode, eine Handlochabdeckplatte und eine Isolierfolie zwischen der Induktionselektrode und der Handlochabdeckplatte umfasst, wobei eine Schicht der Isolierfolie zwischen die Induktionselektrode und die Handlochabdeckplatte eingespannt ist, um eine Niederspannungsarmkapazität des Spannungsteilers zu bilden, wobei eine Hochspannungsarmkapazität zwischen der Induktionselektrode und einem Hochspannungsbus gebildet ist, um den kapazitiven Spannungsteiler zu bilden, um so eine transiente Überspannung zwischen dem Hochspannungsbus und einem GIS-Gehäuse zu messen; der Primärtransientenstromsensor eine Hohlspule verwendet und die Hohlspule zur Messung an einer Strommessseite des Hochspannungsbusses ummantelt ist; eine Abschirmbox an einer GIS-Zugöffnung installiert ist und die Hochgeschwindigkeitssammelkarte, ein Auslösesystem, ein Lichtwellenleitersteuersystem und eine Energieversorgung des Testsystems in der Abschirmbox angeordnet sind.

9. Testverfahren, das ein elektronisches Messwandlertestsystem für ein GIS nach einem der Ansprüche 7 oder 8 verwendet, **dadurch gekennzeichnet, dass** das Verfahren die folgenden Schritte umfasst:

Schritt 1: Etablieren des elektronischen Messwandlertestsystems für ein GIS basierend auf einem Trennschalter;
Schritt 2: Sicherstellen der Anordnung der Zusammenführeinheit im Steuerschrank, wobei die Zusammenführeinheit normal versorgt wird, um zu laufen, und normal mit dem Fehlerschreiber kommuniziert;
Schritt 3: Schließen des zweiten Trennschalters, Lokalisieren des ersten Trennschalters in einem offenen Zustand und Erhöhen der Ausgangsspannung des Hochspannungstestwandlers auf $U_m/\sqrt{3}$, wobei sich UM auf die höchste Spannung in der Schaltung bezieht;
Schritt 4: Schließen des ersten Trennschalters und Aufnehmen von zwei Teilen von Testdaten des Testsystems und sekundäre Fehleraufzeichnungsdaten;
Schritt 5: Einschalten des ersten Trennschalters DS1 2 Minuten später und Aufnehmen der zwei Teile von Testdaten des Testsystems und der sekundären Fehleraufzeichnungsdaten;
Schritt 6: Wiederholen des Schritts 4 bis zum Schritt 5 für 9 mal, nämlich Ausführen des Öffnungs-/Schließbetriebs des ersten Trennschalters für 10 mal insgesamt.

10. Testverfahren nach Anspruch 9, **dadurch gekennzeichnet, dass** es ferner die folgenden Schritte umfasst:

Schritt 7: Schließen des ersten Trennschalters, Lokalisieren des zweiten Trennschalters in einem offenen Zustand und Erhöhen der Ausgangsspannung des Hochspannungstestwandlers auf $U_m/\sqrt{3}$, wobei sich UM auf die höchste Spannung der Schaltung bezieht;
Schritt 8: Schließen des zweiten Trennschalters und Aufnehmen von Testdaten 101 und 104 des Primärtran-sientitentestsystems und sekundärer Fehleraufzeichnungsdaten;

Schritt 9: Anschalten des zweiten Trennschalters DS2 2 Minuten später und Aufzeichnen der Testdaten 101 und 104 des Primärtransientestsystems und der sekundären Fehleraufzeichnungsdaten;
Schritt 10: Wiederholen der Schritte 8 bis 9 für 9 mal, nämlich Ausführen des Öffnungs-/Schließbetriebs des zweiten Trennschalters DS2 für 10 mal insgesamt, und dann Beenden des Tests.

**Revendications**

1. Système de test de transformateur d'instrument électronique GIS basé sur un faible courant de capacité d'ouverture-fermeture d'un commutateur d'isolation, comprenant :

   deux boîtiers, dans lequel une canalisation GIS est agencée entre les deux boîtiers, un boîtier est un boîtier d'alimentation électrique (105), le boîtier d'alimentation électrique est raccordé à un transformateur de test à haute tension (U1) et à un diviseur de tension capacitive (C1) utilisé pour protéger une alimentation électrique, qui sont raccordés parallèlement l'un à l'autre, le diviseur de tension capacitive est utilisé pour réduire un effet de résonance provoqué par une impédance d'alimentation électrique supérieure, l'autre boîtier est un boîtier de charge (106), le boîtier de charge est raccordé à un condensateur de charge (C2), et un premier commutateur d'isolation (DS1) est agencé dans la canalisation GIS à proximité du boîtier d'alimentation électrique, **caractérisé en ce que** :

   un premier système de test transitoire primaire d'étalonnage (101), un premier transformateur d'instrument électronique à tester (102), un deuxième transformateur de tension électronique à tester (103) et un deuxième système de test de tension transitoire primaire d'étalonnage (104) sont agencés entre le premier commutateur d'isolation et le boîtier de charge, dans lequel le premier transformateur d'instrument électronique à tester est à proximité du premier commutateur d'isolation, le deuxième transformateur de tension électronique à tester est à proximité du boîtier de charge, le premier transformateur d'instrument électronique à tester est un transformateur de courant électronique ou un transformateur combiné de courant et de tension électronique, le premier système de test transitoire primaire d'étalonnage est agencé à proximité du premier transformateur d'instrument électronique à tester et est un système de test de courant transitoire primaire correspondant au premier transformateur d'instrument électronique à tester ou une combinaison de systèmes de test de tension et de courant transitoire primaire, et le deuxième système de test de tension transitoire primaire d'étalonnage est agencé à proximité du deuxième transformateur de tension électronique à tester ; une extrémité d'un convertisseur secondaire est raccordée aux transformateurs d'instrument électronique à tester, l'autre extrémité du convertisseur secondaire est raccordée à une unité de fusion, l'autre extrémité de l'unité de fusion est raccordée à un enregistreur de défaut, et l'enregistreur de défaut est utilisé pour raccorder la sortie de l'unité de fusion.

2. Système de test de transformateur d'instrument électronique GIS basé sur le faible courant de capacité d'ouverture-fermeture du commutateur d'isolation selon la revendication 1, dans lequel un deuxième commutateur d'isolation est en outre agencé entre le premier transformateur d'instrument électronique à tester et le deuxième transformateur de tension électronique à tester.

3. Système de test de transformateur d'instrument électronique GIS basé sur le faible courant de capacité d'ouverture-fermeture du commutateur d'isolation selon la revendication 2, dans lequel la longueur de la canalisation GIS est ajustable, un rail coulissant pour l'expansion et la contraction de la canalisation GIS est agencé à un fond du boîtier d'alimentation électrique, et le rail coulissant peut coulisser vers la gauche et la droite.

4. Système de test de transformateur d'instrument électronique GIS basé sur le faible courant de capacité d'ouverture-fermeture du commutateur d'isolation selon la revendication 2, **caractérisé en ce que** :
   des valeurs numériques de faible courant de capacité d'ouverture-fermeture des premier et deuxième commutateurs d'isolation sont de préférence 0,1-0,8 A.

5. Système de test de transformateur d'instrument électronique GIS basé sur le faible courant de capacité d'ouverture-fermeture du commutateur d'isolation selon la revendication 2, **caractérisé en ce que** : le courant de sortie du transformateur de test à haute tension est de 2 A ; et les premier et deuxième commutateurs d'isolation sont pourvus de mécanismes de fonctionnement électrique et d'alimentations électriques de fonctionnement de 220 VCA.

**6.** Système de test de transformateur d'instrument électronique GIS basé sur le faible courant de capacité d'ouverture-fermeture du commutateur d'isolation selon l'une quelconque des revendications 3 à 5, dans lequel une armoire de commande est installée à proximité de la canalisation GIS, et le convertisseur secondaire et l'unité de fusion sont placés dans l'armoire de commande.

**7.** Système de test de transformateur d'instrument électronique GIS basé sur le faible courant de capacité d'ouverture-fermeture du commutateur d'isolation selon la revendication 6, dans lequel le système de test de courant transitoire primaire comprend un capteur de courant transitoire primaire, le système de test de tension transitoire primaire comprend un capteur de tension transitoire primaire, une carte de collecte à grande vitesse et un ordinateur supérieur de mesure, la carte de collecte à grande vitesse 3 collecte respectivement les sorties du capteur de courant transitoire primaire et du capteur de tension transitoire primaire et transmet les sorties à l'ordinateur supérieur de mesure dans un mode de transmission de données.

**8.** Système de test de transformateur d'instrument électronique GIS basé sur le faible courant de capacité d'ouverture-fermeture du commutateur d'isolation selon la revendication 7, dans lequel le capteur de tension transitoire primaire est un capteur de tension de type à prise, le capteur de tension de type à prise comprend une électrode d'induction installée dans une prise GIS, une plaque de couvercle de prise, et un film isolant situé entre l'électrode d'induction et la plaque de couvercle de prise, une couche du film isolant est fixée entre l'électrode d'induction et la plaque de couvercle de prise pour former une capacité de bras de basse tension du diviseur de tension, une capacité de bras de haute tension est formée entre l'électrode d'induction et un bus de haute tension pour constituer le diviseur de tension capacitive, de manière à mesurer une surtension transitoire entre le bus de haute tension et un boîtier GIS ; le capteur de courant transitoire primaire adopte une bobine creuse, et la bobine creuse est emmanchée à un site de mesure de courant du bus de haute tension pour une mesure ; un coffret de protection est installé à une ouverture de tirage GIS, et la carte de collecte à grande vitesse, un système de déclenchement, un système de commande à fibre optique et une alimentation électrique du système de test sont placés dans le coffret de protection.

**9.** Procédé de test utilisant le système de test de transformateur d'instrument électronique GIS selon la revendication 7 ou 8, **caractérisé en ce que** ledit procédé comprend les étapes suivantes :

étape 1 : établir le système de test de transformateur d'instrument électronique GIS sur la base du commutateur d'isolation ;
étape 2 : s'assurer de placer l'unité de fusion dans l'armoire de commande, dans lequel l'unité de fusion est normalement mise sous tension pour fonctionner et communique normalement avec l'enregistreur de défaut ;
étape 3 : fermer le deuxième commutateur d'isolation, mettre le premier commutateur d'isolation dans un état d'ouverture, et augmenter la tension de sortie du transformateur de test à haute tension à $Um/\sqrt{3}$, dans lequel Um représente la plus haute tension du circuit ;
étape 4 : fermer le premier commutateur d'isolation, et enregistrer deux éléments de données de test du système de test et des données d'enregistrement de défaut secondaire ;
étape 5 : mettre sous tension le premier commutateur d'isolation DS1 deux minutes plus tard, et enregistrer les deux éléments de données de test du système de test et les données d'enregistrement de défaut secondaire ;
étape 6 : répéter neuf fois l'étape 4 et l'étape 5, c'est-à-dire effectuer l'opération d'ouverture-fermeture du premier commutateur d'isolation 10 fois au total.

**10.** Procédé de test selon la revendication 9, **caractérisé en ce qu'**il comprend en outre les étapes suivantes :

étape 7 : fermer le premier commutateur d'isolation, mettre le deuxième commutateur d'isolation dans un état d'ouverture, et augmenter la tension de sortie du transformateur de test à haute tension à $Um/\sqrt{3}$, dans lequel Um représente la plus haute tension du circuit ;
étape 8 : fermer le deuxième commutateur d'isolation, et enregistrer des données de test 101 et 104 du système de test transitoire primaire et des données d'enregistrement de défaut secondaire ;
étape 9 : mettre sous tension le deuxième commutateur d'isolation DS2 deux minutes plus tard, et enregistrer les données de test 101 et 104 du système de test transitoire primaire et les données d'enregistrement de défaut secondaire ;
étape 10 : répéter neuf fois l'étape 8 et l'étape 9, c'est-à-dire effectuer l'opération d'ouverture-fermeture du deuxième commutateur d'isolation DS2 10 fois au total, puis terminer le test.

Figure 1

Figure 2

Figure 3

201

High voltage bus

202

206    205

203    204

Electrode

Figure 4

Shielding box 301

Discharge
electromag
netic wave
reception

Storage battery 302

Inverter power
supply 303

Computer control
and
data acquisition

Optical fiber
to each
measurement
point

Collection card

PicoScope

Optical fiber
to each
measurement
point

Synchronous
trigger of multiple
measurement
points

Hand hole type
capacitive voltage divider

GIS

Figure 5

Shielding box 301

Storage battery 302

Inverter power supply 303

Computer
control and
data
acquisition

Optical fiber to
each
measurement
point

Collection card 113

PicoScope

Output of hollow coil of PCB board

GIS

Figure 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101881813
- CN 101504432
- CN 102565647
- GB 19852004 A